# EUROPÄISCHE PATENTANMELDUNG

(11) **EP 0 755 073 A1**
(43) Veröffentlichungstag der Anmeldung: **22.01.1997**
(21) Anmeldenummer: 96111247.1
(22) Anmeldetag: 11.07.1996
(51) Int. Cl.: H01L 21/8238, H01L 21/266, H01L 27/092

(54) **Verfahren zur Herstellung von Halbleiterwannen verschiedener Dotierungshöhe**

(30) Priorität: 18.07.1995 DE 19526183
(71) Anmelder: SIEMENS AKTIENGESELLSCHAFT, 80333 München (DE)
(72) Erfinder: Pfirsch, Frank, Dr. rer.nat., 81545 München (DE)

(57) **Zusammenfassung**

Bei einem Verfahren zur Herstellung von mindestens zwei MOS- Transistoren (1, 2) in einem Halbleiterkörper (9) wird ein Wannendotierungsgebiet (3) erzeugt, in dem die Dotierungsmaske im Abschnitt der zu erzeugenden Wanne (3) mit für den Dotierstoff nichtdurchlässigen Bereichen (30a-30e) strukturiert ist. Nach einer Diffusion stellt sich in der Wanne (3) eine Ladungsträgerkonzentration ein, die im Vergleich zu einer gleichzeitig hergestellten herkömmlichen Wanne (10) niedriger ist. Die Wanne (3) dient als Ladungsträgersenke für einen Transistor (1) von hoher Spannungsfestigkeit, während der in der herkömmlichen Wanne hergestellte Transistor (2) niedrige Spannungsfestigkeit, aber geringe Fläche für hohe Packungsdichte aufweist.

## Beschreibung

Die Erfindung betrifft ein Verfahren zur Herstellung von mindestens zwei Transistoren in einem Halbleiterkörper unter Verwendung von Wannendotierungsgebieten.

Die Spannungsfestigkeit von Transistoren hängt bekanntlich von der Ausdehnung der Raumladungszone im Ladungsträgersenkengebiet des Transistors, das bei MOS-Transistoren das Draingebiet und bei Bipolartransistoren das Kollektorgebiet ist, ab. Um eine entsprechend große Ausdehnung der Raumladungszone zu erhalten, sind Gebiete hinreichend niedriger Dotierstoffkonzentration erforderlich. Die realisierten Transistoren weisen dann eine hohe Durchbruchsspannung auf.

Heutzutage besteht das Bestreben, solche Bauelemente mit hoher Spannungsfestigkeit und andere Bauelemente mit niedriger Spannungsfestigkeit auf einem einzigen integrierten Halbleiterchip zu realisieren. Die erstgenannten Transistoren werden zum Schalten hoher Spannungen und/oder hoher Ströme verwendet. Die zweitgenannten Transistoren werden zur Realisierung von digitalen Logikfunktionen oder Analogfunktionen verwendet. Da zur Schaltungstechnischen Ausführung dieser Funktionen üblicherweise eine Vielzahl von Transistoren erforderlich ist, soll die Packungsdichte möglichst hoch und die von einem Transistor besetzte Fläche möglichst gering sein.

In solchen integrierten Schaltungschips wurden bisher für die Transistoren mit der hohen Spannungsfestigkeit Wannendotierungsgebiete verwendet. Wenn diese Wannen niedrig dotiert werden, um eine entsprechend hohe Spannungsfestigkeit zu erreichen, und außerdem der Wannenherstellungsschritt gleichzeitig zur Herstellung von komplementären CMOS-Transistoren mit der niedrigen Spannungsfestigkeit verwendet wird, ist die Packungsdichte für die CMOS-Transistoren der niedrigen Spannungsfestigkeit wegen der sich ergebenden großen Kanallängen relativ niedrig. Wenn andererseits verschiedene Herstellungsschritte zur Erzeugung der jeweiligen Wannengebiete für Transistoren hoher bzw. niedriger Spannungsfestigkeit angewandt werden, kann zwar der Flächennachteil verringert werden, es sind jedoch zusätzliche fotolithografische Schritte und Implantationsschritte notwendig. Die Herstellung solcher Schaltungen ist folglich aufwendig und dementsprechend teuer.

In der EP-A-0 387 999 sowie der EP-A-0 242 623 sind Verfahren zur Herstellung von für digitale Signalverarbeitung geeigneten MOS-Transistoren und von für die Verarbeitung von Hochvoltsignalen geeigneten MOS-Transistoren in einer einzigen integrierten Schaltung beschrieben. Es werden Wannendotierungsgebiete, die erstgenannte Transistoren aufnehmen, und Wannendotierungsgebiete, die als Elektrodenanschlüsse für letztgenannte Transistoren dienen, erzeugt. In einer anderen Literaturstelle, IEEE Journal of Solid State Circuits, Band SC-21, Nr. 2, April 1986, Seiten 293 - 296, "An Enhanced Fully Scaled 1.2-µm CMOS Process For Analog Applications", Robert K. Reich at al. ist ein ähnliches Herstellungsverfahren mit einem Hochvolt-Bipolartransistor.

Die Aufgabe der Erfindung besteht darin, ein Verfahren zur Herstellung von mindestens zwei Transistoren unterschiedlicher Spannungsfestigkeit auf einem einzigen Halbleiterchip anzugeben, das mit möglichst wenigen Prozeßschritten ausführbar ist.

Diese Aufgabe wird durch ein Verfahren nach den Merkmalen des Patentanspruchs 1 angegeben.

Vorteilhafte Weiterbildungen des Verfahrens sind in den Unteransprüchen angegeben.

Durch die Maskierung der Dotiermaske innerhalb des für den Transistor der hohen Spannungsfestigkeit vorgesehenen zweiten Wannendotierungsgebiets wird erreicht, daß eine niedrigere Ladungsträgermenge in den Halbleiterkörper eintritt, als beim ersten Wannendotierungsgebiet, das zur Aufnahme des komplementären Transistors der niedrigen Spannungsfestigkeit dient. Nach der durch die Wärmebehandlung bewirkten Diffusion stellt sich in der zweiten Wanne insgesamt eine niedrigere Dotierstoffkonzentration ein als in der ersten Wanne. Die zweite Wanne wird nun als Draingebiet des MOS-Transistors der hohen Spannungsfestigkeit verwendet. Wegen der niedrigen Dotierstoffkonzentration in der zweiten Wanne weist dieser MOS-Transistor eine hohe Spannungsfestigkeit auf. Bei der Herstellung werden keine zusätzlichen Maskenschritte eingeführt. Die Parameter für den Dotierungsvorgang (Behandlungszeit, Ladungsträgerdosis etc.) können so gewählt werden, daß sich für die ersten Wannen für die MOS-Transistoren der niedrigen Spannungsfestigkeit möglichst geringe Wannengrößen ergeben und somit die Packungsdichte hoch ist. Die von der Ladungsträgerkonzentration in den zweiten Wannen abhängige Höhe der Spannungsfestigkeit kann dadurch eingestellt werden, daß das Verhältnis von durchlässigen zu nichtdurchlässigen Bereichen der Dotierungsmaske verändert wird. Insgesamt ist durch das Verfahren eine integrierte Schaltung mit Transistoren hoher Spannungsfestigkeit und weiteren Transistoren für niedrige Spannungsfestigkeit bei hoher Packungsdichte herstellbar. Das Verfahren benötigt keine zusätzlichen Maskenschritte.

Die Struktur der für den Dotierstoff durchlässigen und nichtdurchlässigen Bereiche der Dotierungsmaske wird entsprechend dem gewünschten Dotierungsprofil und der gewünschten Ladungsträgerkonzentration eingestellt. Vorzugsweise werden beide Gebiete streifenförmig ausgeführt mit konstantem Streifenabstand und konstanter Streifenbreite längs eines Streifens sowie in bezug auf alle Streifen untereinander. Durch sich verändernde Abstände kann ein Ladungsträgergradient erzeugt werden. Sich verringernde Abstände zum Drain hin sorgen dafür, die Gefahr eines Lawinendurchbruchs in der Driftstrecke des Draingebiets zu verringern. Prinzipiell kann jegliches regelmäßiges Muster verwendet werden. Beispielsweise sind die durchlässigen Bereiche in Rechteckform ausgeführt, mit jeweils konstantem Abstand voneinander. Die minimale Größe der nichtdurchlässigen und durchlässigen Bereiche liegt in der Größenordnung der durch den Herstellungsprozeß minimal herstellbaren Strukturgröße. Diese ist üblicherweise mit der minimal herstellbaren Gatelänge eines MOS-Transistors gegeben. Die maximale Größe eines für den Dotierstoff nichtdurchlässigen Bereichs der Dotierungsmaske ist derart zu wählen, daß sich unterhalb des von diesem Bereich oberflächlich bedeckten Halbleiterkörpers noch ein möglichst gleichförmiger Verlauf der Dotierstoffkonzentration ergibt. Vorzugsweise liegen Breite und Abstand der Streifen jeweils in der Größenordnung der minimal herstellbaren Struktur. Damit ergibt sich ein Flächenverhältnis von nichtdurchlässigem Bereich und durchlässigem Bereich in der Dotierstoffmaske von 1:1. Bei der Verwendung von rechteckförmigen durchlässigen Bereichen der Kantenlänge L, die mit einem Abstand L voneinander angeordnet sind, ergibt sich ein Flächenverhältnis von 3:1. Das Flächenverhältnis wird je nach gewünschter zu erzeugender Dotierstoffkonzentration in der zweiten Wanne für den Transistor der niedrigen Spannungsfestigkeit eingestellt.

In bevorzugten Ausführungsformen kann ein PMOS-Transistor für Hochvoltanwendungen und ein N-Kanal-MOS-Transistor für digitale und analoge Signalverarbeitungsfunktionen auf einem Chip hergestellt werden oder ein DMOS-Leistungstransistor zusammen mit einem P-Kanal-MOS-Transistor für die Signalverarbeitungsfunktionen.

In der europäischen Patentanmeldung EP-A2-0 176 778 ist ein Verfahren zum Herstellen eines pn-Übergangs beschrieben, bei dem eine allzu enge Krümmung am Rand eines Dotierungsprofils, die zu einer hohen Feldstärkebelastung führen würde, vermieden werden soll, indem ein allmähliches Ansteigen und Auslaufen der Dotierung am Rand hergestellt wird, so daß die Durchbruchsspannung insgesamt erhöht wird. Dies wird dadurch erreicht, daß die Dotierungsmaske Öffnungen aufweist, die mit zunehmendem Abstand vom Rand kleiner bemessen sind und/oder weiter voneinander entfernt sind.

In einer anderen europäischen Patentanmeldung EP-A2-0 262 356 ist ein Verfahren zur Herstellung eines pn-Übergangs beschrieben, bei dem eine oberflächlich auf dem Halbleiterkörper aufgebrachte Schicht verwendet ist, in die Dotierstoff eingebracht wird. Die Schicht wird derart strukturiert, daß Schichtanteile ganz oder teilweise entfernt werden. Durch nachfolgendes Tempern wird für eine unterschiedliche Dotierstoffkonzentration in dem darunter liegenden Halbleiterkörper gesorgt. Durch unterschiedliche Abstände der nicht entfernten Strukturelemente wird für einen allmählichen Anstieg der Grenzfläche der eingebrachten Dotierung am Rand des Dotierungsgebiets gesorgt oder auch für einen allmählichen Übergang zwischen zwei Dotierungsgebieten.

Nachfolgend wird die Erfindung anhand der in der Zeichnung dargestellten beiden Ausführungsbeispiele näher beschrieben.

Es zeigen:
- Figur 1: ein erstes Ausführungsbeispiel mit einem PMOS-Hochvolttransistor und einem N-Kanal-MOS-Feldeffekttransistor für Signalverarbeitung,
- Figur 2: ein zweites Ausführungsbeispiel mit einem DMOS-Leistungstransistor und einem P-Kanal-MOS-Transistor für die Signalverarbeitung und
- Figur 3a und 3b: einen Querschnitt durch eine Dotierungsmaske und das sich ergebende Dotierungsprofil.

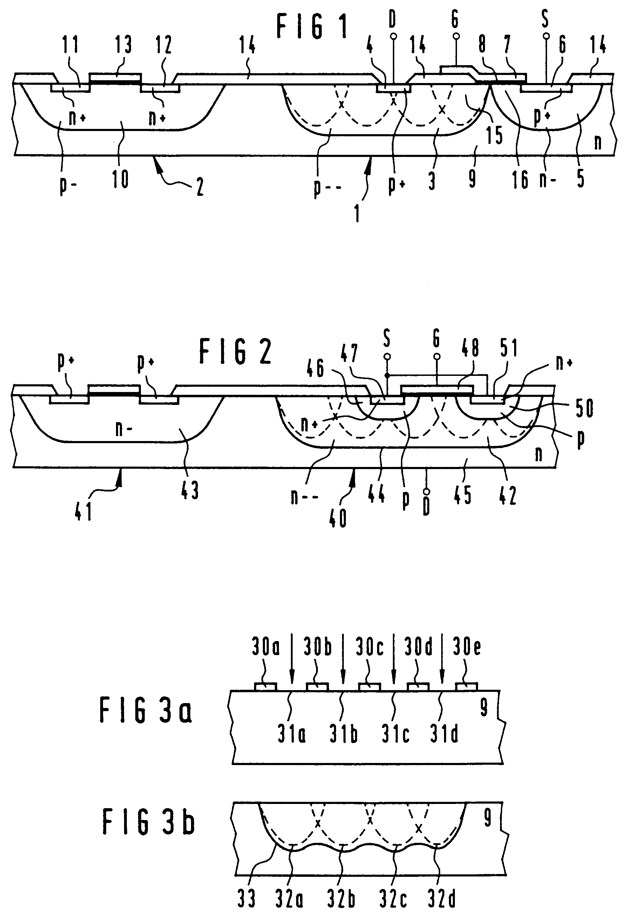

In der Figur 1 ist ein Querschnitt durch einen Halbleiterkörper gezeigt, in dem ein PMOS-Hochvolttransistor 1 und ein eine digitale Schaltfunktion oder eine analoge Signalverarbeitungsfunktion ausführender n-Kanal-MOS-Feldeffekttransistor 2 realisiert sind. Der Transistor 1 umfaßt ein p-leitendes Draindotierungsgebiet 3, das in Form einer Wanne ausgeführt ist. Bei einer Wanne handelt es sich um ein Dotierungsgebiet mit relativ niedriger Dotierung (10¹⁶...10¹⁷ cm⁻³), das relativ tief von der Oberfläche des Halbleiterkörpers her in diesen hineinreicht. Die Dotierungskonzentration und -art ist symbolisch mit p⁻⁻ angegeben. Innerhalb der Wanne 3 ist ein hochdotiertes, p-leitendes (p⁺) Anschlußdotierungsgebiet für den Drainanschluß 4 angeordnet. Dies hat überlicherweise eine um mindestens zwei Größenordnungen (Zehnerpotenzen) höhere Dotierstoffkonzentration. Neben der Wanne 3 ist eine n⁻-leitende Wanne 5 angeordnet, in der sich der invers leitende Kanal des MOS-Transistors ausbilden kann. Innerhalb der Kanalwanne 5 liegt das p⁺-leitende Sourcegebiet 6. Oberhalb der Kanalwanne 5 ist über einem Gateoxid 8 eine Gateelektrode 7 aus Polysilizium aufgebracht. Der MOS-Transistor 2 umfaßt bekanntlich eine p⁻-Wanne 10, n⁺-leitende Drain- und Sourcegebiete 11, 12 sowie ein Gate 13. Der Halbleiterkörper ist durch ein dickes Feldoxid 14 im wesentlichen bedeckt.

Zur Herstellung der Transistoren wird vorausgesetzt, daß der Halbleiterkörper 9, der ein schwach n-dotiertes Siliziumhalbleitermaterial ist, soweit vorbereitet ist, daß Wannendotierungsgebiete eingebracht werden können. Die Dotierstoffkonzentration des Substrats liegt niedriger als die Dotierstoffkonzentration eines der Wannendotierungsgebiete. Zur Herstellung der Dotierungsgebiete 3, 10 wird auf die Oberfläche des Halbleiterkörpers 9 eine Dotierungsmaske aufgebracht, die im Bereich der Wanne 10 vollständig durchlässig ist für die Dotierstoffe und im Bereich der Wanne 3 den in Figur 3a gezeigten Querschnitt aufweist. Die Maske besteht aus für den Dotierstoff nichtdurchlässigen Bereichen 30a..30e, zwischen diesen nichtdurchlässigen Bereichen angeordneten durchlässigen Bereichen 31a..31d. Die nichtdurchlässigen Bereiche 30 bestehen aus einem geeigneten Lack, die durchlässigen Bereich 31 aus Öffnungen im Lack. Diese Strukturierung wird durch einen fotolithografischen Prozeß aufgebracht. Mittels herkömmlicher Techniken, vorzugsweise Ionenimplantation, wird die Dotierung in den Halbleiterkörper 9 bei den Öffnungen eingebracht. Die Dotierung der Gebiete 3, 10 wird also durch einen gemeinsamen Dotierungsvorgang mit einer einzigen Maske hergestellt. Anschließend wird die Dotierung für das n⁻-Wannengebiet 5 hergestellt.

Am Ende des Implantationsvorgangs befinden sich im Bereich der herzustellenden Wanne 3 unterhalb der Öffnungen 31a..31d Dotierstoffatome, während die Abschnitte im Halbleiterkörper unterhalb der nichtdurchlässigen Maskenbereiche 30a..30e - von Streuungseffekten abgesehen - im wesentlichen keine Dotierstoffatome enthalten. Nachfolgend wird der mit den Implantationen 10, 3, 5 versehene Halbleiterkörper einer Wärmebehandlung unterzogen, so daß eine Ausdiffusion der eingebrachten Dotierstoffe stattfindet. Der Diffusionsvorgang erfolgt mit üblichen Parametern für Temperatur und Zeitdauer. Die unterhalb der Öffnungen 31 der Dotierungsmaske vorliegenden Dotierstoffatome diffundieren seitlich unter die jeweils benachbarten Maskenbereiche 30. Es ergeben sich die in Figur 3b gezeigten jeweiligen diffundierten Dotierstoffverteilungen 32a..32d, die insgesamt einen Verlauf 33 der Grenzfläche zum Halbleitermaterial 9 ergeben. Da während der Implantation nur der die Öffnungen 31 umfassende Anteil der Oberfläche des Halbleiterkörpers 9 der zu erzeugenden Wanne 3 den Implantationsionen ausgesetzt war, wogegen aber im Bereich der zu erzeugenden Wanne 10 die gesamte Oberfläche ausgesetzt war, ist die sich nach der Wärmebehandlung einstellende Dotierstoffkonzentration in der Wanne 3 (p⁻⁻) geringer als in der Wanne 10 (p⁻). Für beide Wannen 3, 10 wird dabei der gleiche Ionenimplantationsschritt mit nur einer Maske und der gleiche Wärmebehandlungsschritt durchgeführt. Zusätzliche Masken und Diffusionsschritte sind nicht notwendig. Die Dotierungsdosis wird so eingestellt, daß sie der üblichen Dotierungsdosis für den Transistor 10 entspricht, so daß der die Transistoren der niedrigen Spannungsfestigkeit enthaltende Flächenabschnitt des Halbleiterchips möglichst dicht gepackt werden kann. Der Transistor 2 ist dabei der komplementäre N-Kanal-Transistor neben einem nicht in derselben Wanne angeordneten P-Kanal-Transistor der die Kleinsignalverarbeitung betreibenden CMOS-Schaltung.

Für die Spannungsfestigkeit des Transistors 1 entscheidend ist der Bereich 15 der Wanne 3, der vom Ende der Drainanschlußdotierung 4 bis zum Kanalende des Kanals 16 in der Wanne 5 reicht. Durch die niedrige p⁻⁻-Dotierung der Wanne 3 kann sich dort eine genügend große Raumladungszone ausbilden, die geeignet ist, hohe Drain-Source-Spannungen, die beispielsweise im Sperrfall des Transistors auftreten, aufzunehmen.

Die Abschnitte 30, 31 der Dotierungsmaske können streifenförmig ausgeführt sein. Bei Längen von 1..2 µm für eine 1 µm-Technologie kann eine Spannungsfestigkeit des Hochvolt-PMOS-Transistors von etwa 80 V erreicht werden. Mit einer unstrukturierten p-Wanne sind nur 35 V erreichbar. Eine weitere Erhöhung der Durchbruchsspannung kann erreicht werden, wenn die Strecke 15 verbreitert wird, wobei weitere der Streifen 30, 31 im Anschluß an den Bereich 30e angefügt werden. Die Höhe der p⁻⁻-Dotierstoffkonzentration der Wanne 3 wird durch Verändern des Flächenverhältnisses von Maskenbereich 30 zu Maskenbereich 31 eingestellt. Für die Strukturierung der Dotierungsmaske oberhalb des zu erzeugenden Wannenbereichs 3 eignet sich jegliches Muster. Vorzugsweise können für die durchlässigen Bereiche der Maske auch Rechtecke und Quadrate verwendet werden mit zueinander konstantem Abstand. Mit den konstanten Abstandsbeziehungen ergibt sich nach der Wärmediffusion in der Wanne 3 ein gleichmäßiger, nahezu konstanter Verlauf der Dotierstoffkonzentration. Verändern sich die Abstände der durchlässigen Bereiche der Dotierungsmaske, wird ein Dotierstoffkonzentrationsgefälle erreicht. Beispielsweise können die Abstände der durchlässigen Bereiche innerhalb der Raumladungszone 15 zum Drainanschlußgebiet 4 hin abnehmen, so daß sich eine Erhöhung der Dotierstoffkonzentration zum Drainanschlußgebiet 4 hin ergibt. Dadurch werden Lawinendurchbrucheffekte vermieden.

Die in der Figur 2 gezeigte Anordnung enthält einen DMOS-Transistor 40 und einen P-Kanal-MOS-Transistor 41 zur Signalverarbeitung. In das schwach n-leitende Halbleitersubstrat werden in einem Schritt die Dotierung für die etwas höher dotierte n⁻⁻-leitende Wanne 42 des DMOS-Transistors 40 sowie die noch höher dotierte n⁻-leitende Wanne 43 des P-Kanal-MOS-Transistors 41 eingebracht. Dabei ist die Dotierungsmaske im Bereich über der zu erzeugenden Wanne 42 entsprechend der Figur 3a strukturiert. Durch Wärmediffusion wird wiederum der Verlauf 44 dieser Wanne erzeugt. Die n⁻⁻-Wanne 42 des Transistors 40 wirkt als Drainelektrode. Im n-Substrat 45 wird der Drainkontaktanschluß D vorgesehen, beispielsweise mittels eines hochdotierten n-leitenden Anschlußdotierungsgebiets; entweder an der der unteren Grenzfläche der Wanne 42 gegenüberliegenden Seite (wie in Figur 2 gezeigt) oder durch ein Anschlußdotierungsgebiet von der Oberfläche des Halbleiterkörpers her (nicht gezeigt). Wiederum ist vorteilhaft, daß eine einzige Dotierungsmaske zur Herstellung der Dotierungsgebiete 43 und 42 verwendet wird, so daß beide Gebiete durch einen gemeinsamen Dotierungsvorgang hergestellt werden.

In die Wanne 42 wird mindestens ein p-leitendes Gebiet 46 eingebracht, in dem sich der Kanal des DMOS-Transistors ausbilden kann. Innerhalb des Gebiets 46 wird dann ein n⁺-leitendes Gebiet 47 eingebracht, das als Sourceelektrode wirkt. Über dem Kanalgebiet 46 zwischen Sourcedotierung 47 und Drainwanne 42 liegt das Steuergate 48. Es können eine Vielzahl von weiteren Kanal- und Sourcegebieten 50 bzw. 51 in die Wanne 42 eingebracht werden, wobei die Gateelektrode 48 entsprechend ausgedehnt wird.

Der Feldstärkeverlauf innerhalb der in der Wanne 42 ausgebildeten Raumladungszone verläuft beim DMOS-Transistor 40 in Richtung zum Halbleitersubstrat 45 und somit zum rückseitigen Drainanschlußkontakt hin. Eine Erhöhung der Spannungsfestigkeit kann hier durch eine Veränderung des Flächenverhältnisses von nichtdurchlässigen Bereichen zu Öffnungen innerhalb der Maske erreicht werden, um die Dotierstoffkonzentration innerhalb der Wanne 42 zu verringern und außerdem damit einhergehend durch eine Vertiefung der Wanne 42 und eine Vertiefung des als Draingebiet wirksamen Halbleiterkörperabschnitts 45.

In den Figuren 1, 2 dienen die Dotierungsgebiete 3 bzw. 42 als Drainelektroden der MOS-Transistoren 1 bzw. 40. Allgemein kann die Erfindung aber angewandt werden auf jegliches Ladungsträgersenkengebiet eines Transistors, wie z.B. auf die Herstellung des Kollektordotierungsgebiets mit verringerter Ladungsträgerkonzentration eines bipolaren pnp- oder npn-Transistors, um eine erhöhte Spannungsfestigkeit zu erreichen.

## Patentansprüche

1. Verfahren zur Herstellung von mindestens zwei Transistoren (2, 1) in einem Halbleiterkörper (9), bei dem in den Halbleiterkörper ein erstes Wannendotierungsgebiet (10) zur Aufnahme des ersten Transistors (2) und ein als Ladungsträgersenkengebiet für den zweiten Transistor (1) dienendes zweites Wannendotierungsgebiet (3) durch eine maskierte Dotierung mit nachfolgender Wärmebehandlung eingebracht werden und die Maske zur Bildung des zweiten Wannendotierungsgebiets (3) für den Dotierstoff durchlässige (31a..31d) und für den Dotierstoff nichtdurchlässige (30a..30e) Bereiche umfaßt.

2. Verfahren nach Anspruch 1,
**dadurch gekennzeichnet**, daß
die für Dotierstoff nichtdurchlässigen Bereiche (30a..30e) der Dotierungsmaske höchstens derart ausgedehnt sind, daß aufgrund der Wärmebehandlung eine Diffusion in die Abschnitte des Halbleiterkörpers, die oberflächlich von den nichtdurchlässigen Bereichen bedeckt sind, derart erfolgt, daß sich ein im wesentlichen gleichmäßiger Verlauf (33) der Dotierstoffkonzentration im zweiten Wannendotierungsgebiet ergibt.

3. Verfahren nach einem der Ansprüche 1 bis 2,
**dadurch gekennzeichnet**, daß
die durchlässigen Bereiche (31a..31d) von den nichtdurchlässigen (30a..30e) Bereichen umgeben werden und voneinander jeweils konstanten Abstand aufweisen.

4. Verfahren nach einem der Ansprüche 1 bis 3,
**gekennzeichnet durch**
streifenförmige Ausbildung der Bereiche (30a..30e, 31a..31d), wobei die durchlässigen Bereiche voneinander gleichen Abstand aufweisen.

5. Verfahren nach einem der Ansprüche 1 bis 4,
**dadurch gekennzeichnet**, daß
der erste Transistor (2) ein N-Kanal-MOS-Transistor ist und der zweite Transistor (1) ein P-Kanal-MOS-Transistor, daß der Halbleiterkörper (9) n-leitfähig ist und die darin eingebrachten ersten und zweiten Wannendotierungsgebiete (3, 10) p-leitfähig sind, daß neben dem zweiten Wannendotierungsgebiet (3) ein n-leitfähiges weiteres Wannendotierungsgebiet (5) in den Halbleiterkörper (9) als Kanalgebiet eingebracht wird und darin ein p-leitfähiges Gebiet (6), daß das p-leitfähige Gebiet (6) als Source des zweiten MOS-Transistors (1) und das zweite Wannendotierungsgebiet (3) als Drain kontaktiert werden.

6. Verfahren nach einem der Ansprüche 1 bis 4,
**dadurch gekennzeichnet**, daß
der erste Transistor (41) ein P-Kanal-MOS-Transistor ist und der zweite Transistor (40) ein N-Kanal-MOS-Transistor, daß der Halbleiterkörper (45) n-leitfähig ist und die darin eingebrachten ersten und zweiten Wannendotierungsgebiete (43, 42) n-leitfähig sind, daß in das zweite Wannendotierungsgebiet (42) mindestens ein p-leitfähiges Gebiet (46, 50) als Kanalgebiet und darin ein n-leitfähiges Gebiet (47, 51) eingebracht sind, daß das n-leitfähige Gebiet (47, 51) als Source des zweiten MOS-Transistors (40) und das zweite Wannendotierungsgebiet (42) als Drain kontaktiert werden.
